(19) Europäisches Patentamt
European Patent Office
Office européen des brevets

(11) **EP 2 912 477 B1**

(12) **EUROPEAN PATENT SPECIFICATION**

(45) Date of publication and mention of the grant of the patent:
**29.08.2018 Bulletin 2018/35**

(21) Application number: **13817978.3**

(22) Date of filing: **11.10.2013**

(51) Int Cl.:
*G01R 21/133* (2006.01)     *G01D 4/00* (2006.01)
*G06Q 50/06* (2012.01)     *G01R 21/00* (2006.01)

(86) International application number:
**PCT/IB2013/059293**

(87) International publication number:
**WO 2014/064570 (01.05.2014 Gazette 2014/18)**

(54) **DEVICE AND METHOD FOR DETERMINING AN INDIVIDUAL POWER REPRESENTATION OF OPERATION STATES**

VORRICHTUNG UND VERFAHREN ZUR BESTIMMUNG EINER INDIVIDUELLEN LEISTUNGSDARSTELLUNG VON BETRIEBSZUSTÄNDEN

DISPOSITIF ET PROCÉDÉ POUR DÉTERMINER UNE REPRÉSENTATION DE PUISSANCE INDIVIDUELLE D'ÉTATS DE FONCTIONNEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.10.2012 US 201261717234 P**

(43) Date of publication of application:
**02.09.2015 Bulletin 2015/36**

(73) Proprietor: **Philips Lighting Holding B.V.**
**5656 AE Eindhoven (NL)**

(72) Inventors:
• **FILIPPI, Alessio**
**NL-5656 AE Eindhoven (NL)**
• **RIETMAN, Ronald**
**NL-5656 AE Eindhoven (NL)**
• **WANG, Ying**
**NL-5656 AE Eindhoven (NL)**

(74) Representative: **van Eeuwijk, Alexander Henricus Waltherus et al**
**Philips Lighting B.V.**
**Philips Lighting Intellectual Property**
**High Tech Campus 45**
**5656 AE Eindhoven (NL)**

(56) References cited:
**EP-A1- 2 026 299     WO-A2-2011/130670**
**US-A1- 2007 203 658     US-A1- 2010 305 889**
**US-A1- 2011 302 125**

**Description**

FIELD OF THE INVENTION

The present invention relates to a device and a method for determining an individual power representation of operation states of a plurality of loads, wherein such information on the individual power representation may furthermore be used for monitoring for malfunctions of a load included in the plurality of loads.

BACKGROUND OF THE INVENTION

Monitoring of the energy consumption of an energy consuming system, e.g. a building, is becoming more and more relevant, as such monitoring enables identification of the potential energy savings, verification of the effectiveness of implemented energy saving strategies, and compliance to demand response (DR) requests. In some countries (e.g. UK) monitoring of energy consumption is even mandatory for large organizations.

A known approach to continuous monitoring of energy consumption requires the installation of dedicated energy meters which are most often designed to bill the customer. If more detailed information is required, more meters are installed to collect the energy consumption of part of the system under consideration.

There exist also other approaches in deriving the energy consumption of individual devices or group of devices by using specially designed meter in combination with energy disaggregation algorithms (see for example, Hart, G.W., Non-intrusive Appliance Load Monitoring, Proc. of IEEE, vol.80, No 12, Dec 1992, pp. 1870-1891). Such energy disaggregation, however, requires to align in the time domain operation state changes and changes in the total energy consumption.

The effective identification of energy savings potentials and the evaluation of the effectiveness of energy saving strategies require a detailed monitoring of the energy consumption. However, a detailed energy monitoring solution requires additional energy meters or special meters. Based on the conventional techniques, more details/insights require a larger investment.

WO 2011/130670 A2 relates to consumption breakdown monitoring through power state sensing. Systems and methods are provided for estimating power breakdowns for a set of one or more appliances inside a building by exploiting a small number of power meters and data indicative of binary power states of individual appliances of such set. In one aspect, a breakdown estimation problem is solved within a tree configuration, and utilizing a single power meter and data indicative of binary power states of a plurality of appliances. Based at least in part on such solution, an estimation quality M metric is derived. In another aspect, such metric can be exploited in a methodology for optimally placing additional power meters to increase the estimation certainty for individual appliances to a desired or intended level. Estimated power breakdown and energy breakdown - individually or collectively referred to as consumption breakdown - rely on measurements and numerical simulations, and can be evaluated in exemplary electrical network utilizing binary sensors.

SUMMARY OF THE INVENTION

It is an object of the present invention to provide a cost effective approach to determining an individual power representation of operation states of a plurality of loads, e.g. to deriving a detailed energy monitoring solution for systems with a building control solution.

In a first aspect of the present invention, a device is presented for determining an individual power representation of each operation state of each load of a plurality of loads, an operation state of a load being a state in which said load consumes or generates energy, said device including an obtaining unit for obtaining a plurality of mutually different data sets, each data set corresponding to a time interval, wherein each data set includes a total energy throughput of the plurality of loads during said time interval and information on all operation states of each load of the plurality of loads during said time interval, the number of data sets being equal to or larger than the combined number of operation states of the plurality of loads, and a calculating unit for calculating a set of the individual power representations of the operation states of the plurality of loads, said set providing a minimization, for all time intervals, of the differences between the obtained total energy throughput of the respective time interval and a combined energy throughput resulting from the operation states of the plurality of loads during said respective time interval, wherein the power representations are linear power representations corresponding to a constant power and including an energy offset and the calculating unit is arranged for calculating an energy throughput of an operation state based on the time period during which the operation state is active within the respective time interval, wherein said energy offset incorporates effects involved with start-up or switch-off of a load. In another aspect of the present invention, a system is presented for determining an individual power representation of each operation state of each load of a plurality of loads, said system including the device according to the present invention, an energy meter for measuring a total energy throughput for a given time interval, and a state monitor for monitoring the operation states of the loads and for generating the information on all operation states of each load of the plurality of loads during said time interval.

In another aspect of the present invention, an arrangement is presented for monitoring for a malfunction of a load in a plurality of loads, said arrangement including the system according to the present invention, and a malfunction monitor for checking for a change in power representations of the operation states of the plurality of loads determined by said system.

In another aspect of the present invention, a method is presented for determining an individual power representation of each operation state of each load of a plurality of loads, an operation state of a load being a state in which said load consumes or generates energy, said method including the steps of obtaining a plurality of mutually different data sets, each data set corresponding to a time interval, wherein each data set includes a total energy throughput of the plurality of loads during said time interval and information on all operation states of each load of the plurality of loads during said time interval, the number of data sets being equal to or larger than the combined number of operation states of the plurality of loads, and calculating a set of the individual power representations of the operation states of the plurality of loads, said set providing a minimization, for all time intervals, of the differences between the obtained total energy throughput of the respective time interval and a combined energy throughput resulting from the operation states of the plurality of loads during said respective time interval, wherein the power representations are linear power representations corresponding to a constant power and including an energy offset and the calculating step includes calculating an energy throughput of an operation state based on the time period during which the operation state is active within the respective time interval, wherein said energy offset incorporates effects involved with start-up or switch-off of a load. In another aspect of the present invention, a computer program is presented for determining an individual power representation of each operation state of each load of a plurality of loads, the computer program comprising program code means for causing the device according to the present invention to carry out the steps of the method according to the present invention when the computer program is run on said device.

It is to be noted that a load may include two or more sub-loads, which do not necessarily have to be identical to each other. A typical example of such load is a lighting system, wherein the lighting system as the load includes several sub-loads in form of, for example, separate lighting elements like LEDs or light bulbs.

The term "mutually different data sets" is to be understood as indicating that any two of the involved data sets are not identical to each other. This, however, does not exclude that there might be overlapping time intervals involved, e.g. in a case in which an energy meter is provided that is read every 15 minutes and which reports the average power used over the last 30 minutes, or in a case in which there are more than one energy meter provided (each measuring the total throughput) with the respective time intervals partially overlapping, e.g. meter A measuring the throughput for the full hour (e.g. 8:00 to 9:00, 9:00 to 10:00, ...) and meter B measuring the throughput with an offset of 30 min (e.g. 8:30 to 9:30, 9:30 to 10:30, ...).

A data set may furthermore be based on multiple measurements, e.g. in averaged form, if there are multiple energy meters provided for measuring the same energy throughput.

Taking into account that some energy consuming systems, such as buildings for instance, have already installed a building management system to manage from a central location their subsystems, it was realized that knowledge about the operation states of the loads involved may be used for determining the individual energy consumption from a total energy consumption. A building management system may handle, for instance, changing the status of the light, setting the proper target temperature for the heating, ventilation and air conditioning system (HVAC), programming specific schedules and similar actions, wherein the timing of a change of state of each sub-system is known.

An interesting implementation of the present invention is being able to provide a detailed energy consumption of a system (for instance a building) having a central (building) management system and a standard energy meter.

The invention is based on the insight of associating the observed changes in the overall power consumption to the control signals used by the management system.

For instance, if the building management system indicates that the lights are switched ON at 10.00 in the morning and a change in power consumption of 1 kW at 10.00 in the morning is observed, one can infer that the lights controlled by that particular signal have a power consumption of 1 kW.

In a more realistic scenario, there are many control signals and they are usually not aligned in time with the energy meter and it's therefore not straightforward to associate the proper power consumption to each controller.

If one might assume that the power consumption of the controlled devices is completely determined by the state of the controller and the time of the last switch, every meter reading can be represented as the combination of the active devices during the last meter period and the devices that changed state during the last meter period. The contribution of each device to the current meter reading depends on the time the device has been active before the current meter reading.

It is realized that (1) each controller controls one or more devices and furthermore can be characterized by a finite set of states, for example "on"/"Off", "high"/"low"/"off', or "heating"/"cooling", and (2) after a controller is switched, the (time-dependent) energy consumption of the devices under its control depends only on the new state of the controller and the amount of time elapsed after the state switch.

In other words, the energy consumption of the controlled devices is determined completely by the state of the controller and the time of the last switch.

An energy meter measures the total energy consumed by all devices under control of a set of controllers. The energy meter may be sampled (more or less) regularly, e.g. at times $t_0$, $t_1$, $t_2$ ... with readings $E_0$, $E_1$, $E_2$ .... Accordingly, the mean power consumption in the interval $[t_{k-1}, t_k)$ is $S_k = (E_k - E_{k-1})/(t_k - t_{k-1})$.

The controller data of the j-th controller is given, for example, as a set of switching times and states to which the controller switches at those times: $(T_{j1}, s_{j1})$, $(T_{j2}, s_{j2})$, ... .

In view of the above, the power consumption $P_j(t)$ at time t of the devices controlled by the j-th controller equals

$$P_j(t) = \sum_n P\left(j, s_{jn}; t - T_{jn}\right) I\left\{T_{jn} \leq t < T_{jn+1}\right\},$$

where $P(j, s_j; \Delta t)$ denotes the power consumption of these devices at time $\Delta t$ after a switch to state $s_j$, and the indicator function $I\{A\}$ equals 1 if $A$ is true and 0 otherwise. The total energy consumed in the time interval $[t_k, t_k + 1)$ is thus given by

$$\sum_j \int_{t_k}^{t_{k+1}} P_j(t)\, dt.$$

The present invention is about deriving or estimating the functions $P(j, s_j; t)$ as the individual power representations from the readings of the energy meter and the controller data.

In reconstructing $P(j, s_j; t)$ from measurements of consumed energy with a only a finite set of measurements, each giving a sum of integrals of different $P(j, s_j; t)$'s over the respective time intervals, there are mathematical limits to the possibilities. The inventors realized that it is a promising approach in choosing a parameterization of $P(j, s_j; t)$ with a finite set of parameters, and find the best parameter fit to the measurements. For mathematical convenience it is preferable to choose the parameters such that the energy consumed is linear in these parameters, since then the optimization is straightforward and may be based on linear algebra.

A fundamental difference between the approach to energy disaggregation discussing in "Nonintrusive Appliance Load Monitoring" by G.W. Hart (see above) and the present invention is that Hart starts from the current power consumption being known while the state of the involved appliances is not known (see binary functions $a_i(t)$ on page 1873, right column) while the present invention uses knowledge on the state information of the involved loads.

A problem with a straightforward attempt as discussed in the right column of page 1873 and the left column of page 1874 of the Hart paper is that even in knowledge of the consumed power of the appliances the optimization is still ambiguous, as even for given appliance power levels, there may be more than one "binary state vector" that give approximately the same total power consumption.

In the context of the present invention, a similar problem might arise, i.e. for given operation states of the loads involved, there may be more than one set of power levels that give (approximately) the same total power consumption. However, the inventors realized that this issue is not a serious problem in practice.

Supposing that there is more than one load and a set of parameters $P(j, s_j)$ (for simplicity of this discussion, no time dependency is assumed for the parameter, see below) is found for the power levels of device $j$ in state $s_j$ that is a best fit to all the measurements.

One can now construct infinitely many equally good fits by adding $\Delta(j)$ to all $P(j, s_j)$, i.e. give all states of device j the same extra power $\Delta(j)$, in such a way that summing the all $\Delta(j)$ over all devices gives zero. The reason for this is that in each time interval, each device appears exactly once (in some state).

Additional information on the operation states may then further be used.

If, for example, there are only provided loads which consume energy (i.e. no energy providing loads like a generator), all power levels must be non-negative (in the present context, a generator would provide a negative power level corresponding to a negative energy consumption), so the "space" in which the $\Delta(j)$'s can be chosen is limited. Furthermore, for some devices it may be known, for instance, that a certain device state represents an off state in which the power consumption is zero, which reduces this space even further. If this is the case for all (or all-but-one) devices or the problem goes away.

In a "worst case scenario", nothing is known a priori. Still then all we can say is that we know uniquely the differences $P(j, s_j) - P(j, s_{j0})$, where $s_{j0}$ is the state of device j with the lowest power level, and have a "background power consumption" which may be distributed arbitrarily over the devices without affecting the fit to the measurements.

In practice the above does not pose a serious concern, as there is a point in the measurements where the total power consumption is very small (either during normal operation or, if necessary, provided by purpose), which means that the "background power consumption" is also very small.

While the conventionally known approaches in energy disaggregation focuses on a "signature approach" detailed in the Hart paper, which makes it necessary to provide basically a real-time monitoring of the total load / power consumption in order to be able to notice the characteristic signatures involved with switching/state-changing, the present invention, in contrast uses sampling of the total energy consumption of comparatively broad periods, wherein the contributions of the respective loads are modeled based on an appropriate approximation in from of parameterization of the power consumption of the load (e.g. a rectangular (or boxcar) function in the simplified approach of full load present throughout on-time for a two-state-load)), such that the present invention may be considered as employing mathematically integrated signatures of the loads.

It is to be noted that the accuracy and robustness of the determination according to the present invention, in particular in view of measurement noise, may be increased by additionally taking into account further data sets.

Cases in which there are less data sets available than there are operation states provided might also be processed according to the present invention if there is a sufficient number of (sub-)loads which might be combined due to the loads to be combined being in synchronized operation states (e.g. there are two loads which are always switched on and off simultaneously or there are two loads where one is always switched on the moment the other is switch off and vice versa).

In general, if there are fewer equations than unknowns, there are "null vectors" (see below for detailed discussion). If the vector of the power levels is (nearly) orthogonal to these null vectors, the pseudo-inverse still gives good results.

Consider the example $y = Ax$ with $y = \begin{pmatrix} 1968 \\ 24 \\ 1956 \end{pmatrix}$ and $A = \begin{pmatrix} 1 & 1 & 0 & 1 & 1 \\ 1 & 1 & 1 & 0 & 0 \\ 0 & 0 & 1 & 1 & 1 \end{pmatrix}$:

Applying the pseudo-inverse of A on y to obtain a "rough" estimation of x gives $\begin{pmatrix} 9 \\ 9 \\ 6 \\ 975 \\ 975 \end{pmatrix}$, being fairly close to

the "true" $x = \begin{pmatrix} 8 \\ 10 \\ 6 \\ 1000 \\ 950 \end{pmatrix}$. In this case the null vectors are $\begin{pmatrix} 1 \\ -1 \\ 0 \\ 0 \\ 0 \end{pmatrix}$ and $\begin{pmatrix} 0 \\ 0 \\ 0 \\ 1 \\ -1 \end{pmatrix}$, with the inner products of x with these null vectors being relatively small.

In the above example, the first and second state and the fourth and fifth state are always the same, respectively, so the corresponding loads could be considered a sub-loads of a combined load. The power representations are linear power representations and the calculating unit is arranged for calculating an energy throughput of an operation state based on the time period during which the operation state is active within the respective time interval.

A linear power representation allows for a simple parameterization of the power of a load or the energy consumed by said load during a given time, such that the consumed energy linearly depends on the amount of time or portion of the relevant time interval in which the load in the respective operation state. In particular, the power representations are linear power representations and the calculating unit is arranged for calculating an energy throughput of an operation state based on the time period during which the operation state is active within the respective time interval, wherein power representations corresponds to a constant power, respectively.

A simple parameterization of the power is to assume the power remains constant through the operation state, irrespective of the amount of time expired since the operation state was assumed at a switch from a different operation state.

It is found that the results of even such simple parameterization are already good.

In a typical application, the sample rate of the energy meter is quite low and may be, for instance, once per 15 minutes.

Then, according to the Nyquist theorem, one may be able to estimate the functions $P(j, s_j; t)$ completely only if they have no spectral content at frequencies higher than 1/(30 minutes) = 0.56 mHz. In view of this low frequency, the inventors realized an option for simplification, i.e. based on an assumption that $P(j, s_j; t)$ does not depend on t, find the best estimates for $P(j, s_j)$ that fit the data. A mathematical formulation of such simplified approach is: find $P(j, s_j)$ such that

$$\sum_{k} \left( (t_k - t_{k-1}) S_k - \sum_{j,n} P(j, s_{jn}) \int_{t_{k-1}}^{t_k} I\{T_{jn} \leq t < T_{jn+1}\} dt \right)^2$$

is minimized. If no conditions are imposed on the $(j, s_j)$, this corresponds to a standard linear least squares problem of the type "find x such that $\|y - Ax\|^2$ is minimized", of which the solution is well-known: $x = A^+y$, where $A^+$ denotes the pseudo-inverse of $A$, which is given by $A^+ = \lim_{\varepsilon \to 0} + (A^*A + \varepsilon I)^{-1}A^*$, where $A^*$ is the Hermitean conjugate of $A$. If $A$ is invertible, the pseudo-inverse equals the inverse, so then the solution equals $x = A^{-1}y$, if $A$ is not invertible, but $A^*A$ is, the pseudo-inverse equals $(A^*A)^{-1}A^*$. If $A^*A$ is not invertible, there are be many $x$ that minimize $\|y - Ax\|^2$, and the pseudo-inverse gives the solution $x$ of which the norm $\|x\|$ is minimal. If linear conditions are imposed on the $P(j, s_j)$, e.g. that they are positive or bounded from above, the minimization problem becomes a constrained one, for which so called quadratic programming solution techniques are known (see, for example: Practical Optimization, by Philip E. Gill, Walter Murray and Margater H. Wright, Academic Press 1981, chapter 5). Furthermore, the power representations corresponding to a constant power further include an energy offset.

The energy offset may be used for incorporating effects involved with start-up or switch-off, as the energy consumed in a certain state may be modeled more accurately by taking into account the previous operation state and/or special properties of the current operation state. The energy offset provides that there is not just a proportional relation of the consumed (or generated) energy to the time spent in that state (the constant of proportionality being a power level of operation state).

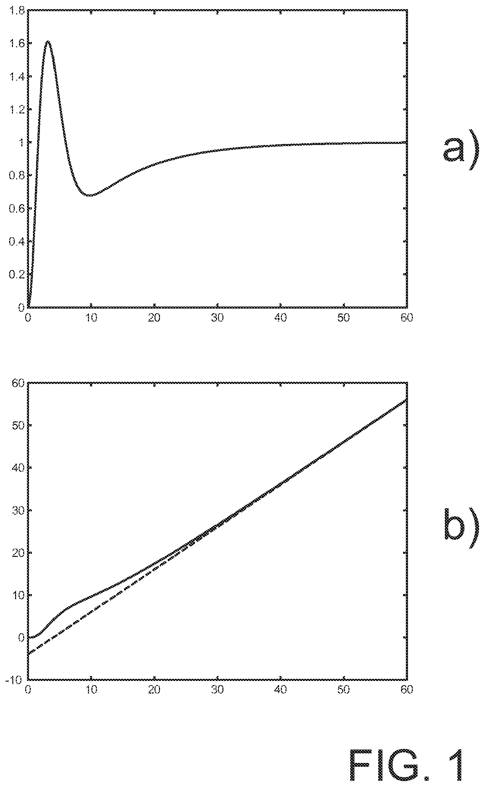

The inventors realized the following: Under the assumption that a power consumption of a device in a certain state basically corresponds to the illustration of Fig. 1a, i.e. to a function of the time since switching to that state. So after a switching time of approximately 30 time units, the power consumption is more or less constant. The corresponding energy consumption is given by the solid line in the Fig 1b, while soon the energy consumption is very well approximated by a linear function $E(t) = Pt + E_{offset}$, illustrated by the dashed line in Fig. 1b.

So if during an interval of duration $T$ and with total power reading $P$ a device A switches from state a to state b at time $\alpha T$, the contribution of device $A$ to the power consumption is $\alpha P_{A,a} + (1 - \alpha)/P_{A,a} + E_{offset,A,a,b}/T$, with the offset depending on the device and the two states. For basically each interval (if necessary excluding those intervals for which a switch occurs too close to the interval boundaries, as otherwise for such intervals the linear approximation may not be accurate enough) an equation can be written down. Combining all equations leads to a linear set in the unknown power levels and energy offsets, which can be solved in a least squares sense.

In a further preferred embodiment, the obtaining unit is arranged for obtaining data sets corresponding to time intervals during which no change of the operation states of the loads occur.

If one only considers meter readings farther in time from the time index of the last control signal than a metering period, to simplifications are achieved, without changes in operation state during a period or interval for which the total energy consumption is obtained, there is no need for considering the particular time fractions of the operation states, while furthermore distortions in the power consumption caused by switching from one operation state to another operation state are substantially excluded. For such sub-set of meter readings $P_k$, the readings are simply the sum of the active states and one obtains

$$P_k = \sum_{j \text{ active in period } k} P(j)$$

This approach can also be reduced to the standard linear least squares problem discussed above, while the available observations are reduced in order to simplify the calculation of the matrix A and to exclude influences of state switching.

Supposing that there a two controllers, A and B, controlling respective loads, wherein each load can be in one of two possible operations states. Using a simple model for the power consumption in each state as a function of time, in which these are constants ($P_{A,1}$, $P_{A,2}$, $P_{B,1}$ and $P_{B,2}$, respectively). The average power reading for each interval in which no state change occurs (consumed energy just divided by time span of the interval) would correspond to the sum of the power consumption of the controlled loads:

In an interval in which both controllers/loads are in operation state 1, and the power reading is $P_{1,1}$, the following equation applies: $P_{A,1} + P_{B,1} = P_{1,1}$.

Similarly, for an interval in which controller/load $A$ is in state 1 and controller/load $B$ in state 2 and the power reading is $P_{1,2}$, the following equations applies:

$$P_{A,1} + P_{B,2} = P_{1,2}.$$

Similarly, for an interval in which controller/load *A* is in state 2 and controller/load B in state 1 and the power reading is $P_{1,2}$, the following equations applies:

$$P_{A,2} + P_{B,1} = P_{2,1}.$$

Similarly, for an interval in which both controllers/loads are in state 2 and the power reading is $P_{2,2}$, the following equations applies: $P_{A,2} + P_{B,2} = P_{2,2}$.

The above equations for these four intervals can be combined into a matrix equation:

$$\begin{pmatrix} 1 & 0 & 1 & 0 \\ 1 & 0 & 0 & 1 \\ 0 & 1 & 1 & 0 \\ 0 & 1 & 0 & 1 \end{pmatrix} \begin{pmatrix} P_{A,1} \\ P_{A,2} \\ P_{B,1} \\ P_{B,2} \end{pmatrix} = \begin{pmatrix} P_{1,1} \\ P_{1,2} \\ P_{2,1} \\ P_{2,2} \end{pmatrix}$$

The matrix $M = \begin{pmatrix} 1 & 0 & 1 & 0 \\ 1 & 0 & 0 & 1 \\ 0 & 1 & 1 & 0 \\ 0 & 1 & 0 & 1 \end{pmatrix}$ has no inverse, whereas nevertheless it is possible to obtain a pseudo-inverse matrix $M^{+} = \frac{1}{8}\begin{pmatrix} 3 & 3 & -1 & -1 \\ -1 & -1 & 3 & 3 \\ 3 & -1 & 3 & -1 \\ -1 & 3 & -1 & 3 \end{pmatrix}$. In the present case, a vector x with least norm that gives a least squares solution to the above matrix equation is of less interest that least squares solutions of which all components (representing power levels) are non-negative (assuming that only power consuming loads are present). This is a problem of constrained quadratic optimization.

Note that the vector $v = (1,1, -1, -1)^{t}$ satisfies $Mv = 0$. That means that if *x* is a least squares solution, $x + \lambda v$ is also a least squares solution for any $\lambda$. If the minimum norm least square solution has some negative components, usually these can all be made non-negative by adding a suitable multiple of *v*. Typically the solution is not going to be unique, because of this vector v. Changing v corresponds to increasing or decreasing all power levels corresponding to controller A by a certain amount, the same for all states, and decreasing or increasing all power levels corresponding to controller B by the same amount.

In a numerical example, for

$$\begin{pmatrix} 1 \\ 2 \\ 3 \\ 4 \end{pmatrix} = \begin{pmatrix} P_{1,1} \\ P_{1,2} \\ P_{2,1} \\ P_{2,2} \end{pmatrix}$$

as least square solutions may be found as

$$\begin{pmatrix} P_{A,1} \\ P_{A,2} \\ P_{B,1} \\ P_{B,2} \end{pmatrix} = \begin{pmatrix} 0.25 \\ 2.25 \\ 0.75 \\ 1.75 \end{pmatrix} + \lambda \begin{pmatrix} 1 \\ 1 \\ -1 \\ -1 \end{pmatrix}$$

with $-0.25 \leq \lambda \leq 0.75$ in view of the non-negativity constraint. In this simplified example the control data and power meter readings do not determine all power levels uniquely, whereas nevertheless the amount of non-uniqueness is limited by the size of the smallest elements of the minimum norm least squares solution.

These and other aspects of the invention will be apparent from and elucidated with reference to the embodiments described hereinafter.

BRIEF DESCRIPTION OF THE DRAWINGS

In the drawings:

Fig. 1    shows an illustration of a change in power consumption after switching from one operation state to another operation state and shows an illustration of a corresponding energy consumption together with a linear approximation thereof,

Fig. 2    shows an illustration of an embodiment of a device for determining an individual power representation of each operation state of each load of a plurality of loads according to the present invention, and

Fig. 3    shows flow chart of an embodiment of a method for determining an individual power representation of each operation state of each load of a plurality of loads according to the present invention.

DETAILED DESCRIPTION OF EMBODIMENTS

Fig. 1 shows an illustration of a change in power consumption after switching from one operation state to another operation state and shows an illustration of corresponding energy consumption together with a linear approximation thereof. A brief discussion of Fig. 1 is already provided above.

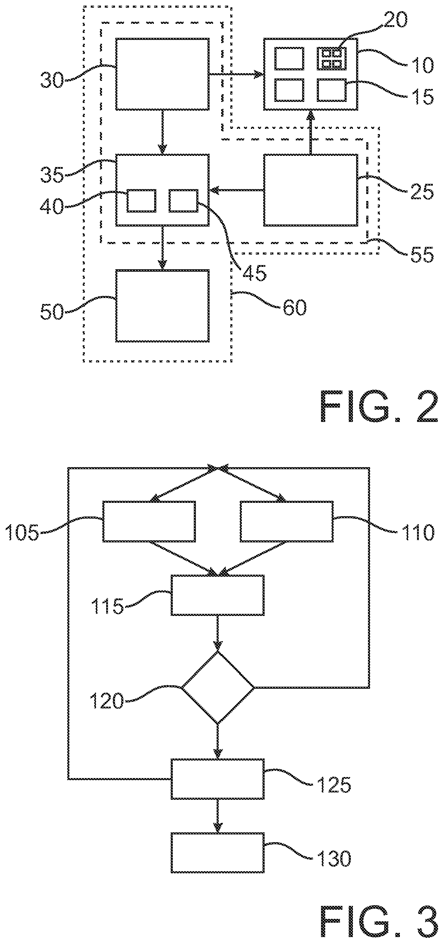

Fig. 2 shows an illustration of an embodiment of a device 35 for determining an individual power representation of each operation state of each load 15 of a plurality 10 of loads according to the present invention. For ease of discussion, the embodiment is limited to the case of the loads 15 being just consuming loads, i.e. the plurality of loads does not include a generator or the like.

A plurality 10 of loads 15 (if applicable including sub-loads 20) is provided by electrical energy, wherein the amount of energy consumed is monitored by an energy meter 25. Furthermore, a control unit 30 is provided which exerts control over the operation states of the loads 15 and also provides the functionality of a state monitor in giving information of the operation states of the loads 15. The energy meter 25 and the control unit 30 provide their information to a determining device 35, which includes an obtaining unit 40 and a calculating unit 45. The determining device 35 is coupled to a malfunction monitor 50. The determining device 35 together with the energy meter 25 and the control unit 30 forms a system 55 for determining an individual power representation of each operation state of each load 15 of a plurality 10 of loads, whereas the system 55 and the malfunction monitor 50 are part of an arrangement 60 for monitoring a malfunction in a load 15 in the plurality 10 of loads.

The control unit 30 controls the operation states of the loads 15 and provides information on such operation states and in particular about changes in the operation states to the determining device 35.

The energy meter 25 measures the energy consumptions of the plurality 10 of loads during respective time intervals, wherein the total energy consumptions of the plurality 10 of loads are measured without information on separate energy consumptions of individual loads 15 being available.

The obtaining unit 40 obtains the information from the energy meter 25 and the control unit 30 in form of a plurality of mutually different data sets. Each data set corresponds to a time interval and includes the total energy consumption (or more generally energy throughput) of the plurality 10 of loads during said time interval. Further, the data set includes also the information provided by the control unit 30 on all operation states of each load of the plurality of loads during said time interval. The number of data sets obtained by the obtaining unit 40 is equal to or larger than the combined number of operation states of the plurality of loads. If more than one parameter is used for the representation of the power of a load 15, the number of data sets is increased accordingly.

Once a sufficient number of data sets is obtained, the data sets are provided to the calculating unit 45 which then calculates a set of the individual power representations of the operation states of the plurality 10 of loads, such that the calculated set provides a minimization, for all time intervals, of the differences between the obtained total energy throughput of the respective time interval and a combined energy throughput resulting from the operation states of the plurality 10 of loads during said respective time interval.

The malfunction monitor 50 is provided with different sets of the individual power representations of the operation states of the plurality 10 of loads and checks for changes between different sets. If there is a change beyond a predetermined threshold in the power consumption or representation of an individual load 15, in particular if the power consumption falls or rises significantly, this might indicate a malfunction of the particular load 15, wherein the malfunction monitor 50 will indicate such possible malfunction candidate.

Fig. 3 shows flow chart of an embodiment of a method for determining an individual power representation of

**EP 2 912 477 B1**

each operation state of each load of a plurality of loads according to the present invention.

In step 105 operation states of loads of a plurality of loads are changed, if applicable and information of the operation states and their changes is provided. In parallel, for a given time interval, the total energy consumption of the plurality of loads is measured in step 110.

The information on the operation states and their changes and the information on the total energy consumption are gathered or obtained in step 115, wherein steps 105, 110 and 115 are repeated until a predetermined number of mutually different data sets including the total energy consumption during the time interval and the corresponding information on the operation states and their changes are obtained (check in step 120).

Based on the data sets, a set of the individual power representations of the operation states of the plurality of loads is calculated in step 125, said set providing a minimization, for all time intervals, of the differences between the obtained total energy throughput of the respective time interval and a combined energy throughput resulting from the operation states of the plurality of loads during said respective time interval.

After such calculating 125, the process returns to steps 105, 110 and 115, wherein furthermore the set of power representations is checked (step 130) for substantial differences to previously obtained set if power representations in order to monitor for possible malfunctions expressing as changes in power consumption.

It is not necessary for the present invention that, for example, the device for determining an individual power representation of each operation state of each load of a plurality of loads, as such controls the operation states by itself, as not the control as such is important but the information on the operation states.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Operations like measuring, determining and calculating can be implemented as program code means of a computer program and/or as dedicated hardware.

A computer program may be stored and/or distributed on a suitable medium, such as an optical storage medium or a solid-state medium, supplied together with or as part of other hardware, but may also be distributed in other forms, such as via the Internet or other wired or wireless telecommunication systems.

**Claims**

1.  A device (35) for determining an individual power representation of each operation state of each load (15) of a plurality (10) of loads, an operation state of a load (15) being a state in which said load (15) consumes or generates energy, said device (35) including
    an obtaining unit (40) for obtaining a plurality of mutually different data sets, each data set corresponding to a time interval, wherein each data set includes a total energy throughput of the plurality (10) of loads during said time interval and information on all operation states of each load (15) of the plurality (10) of loads during said time interval, the number of data sets being equal to or larger than the combined number of operation states of the plurality (10) of loads, and
    a calculating unit (45) for calculating a set of the individual power representations of the operation states of the plurality (10) of loads, said set providing a minimization, for all time intervals, of the differences between the obtained total energy throughput of the respective time interval and a combined energy throughput resulting from the operation states of the plurality (10) of loads during said respective time interval,
    wherein the power representations are linear power representations corresponding to a constant power and including an energy offset and the calculating unit (45) is arranged for calculating an energy throughput of an operation state based on the time period during which the operation state is active within the respective time interval, wherein said energy offset incorporates effects involved with start-up or switch-off of a load.

2.  The device (35) according to claim 1,
    wherein the obtaining unit (40) is arranged for obtaining data sets corresponding to time intervals during which no change of the operation states of the loads occur.

3.  A system (55) for determining an individual power representation of each operation state of each load (15) of a plurality (10) of loads, said system (55) including
    the device (35) according to claim 1,
    an energy meter (25) for measuring a total energy throughput for a given time interval, and
    a state monitor (30) for monitoring the operation states of the loads (15) and for generating the information on all

9

operation states of each load (15) of the plurality (10) of loads during said time interval.

4. An arrangement (60) for monitoring for a malfunction of a load (15) in a plurality (10) of loads, said arrangement (60) including

the system (55) according to claim 3, and

a malfunction monitor (50) for checking for a change in power representations of the operation states of the plurality (10) of loads determined by said system (55).

5. A method for determining an individual power representation of each operation state of each load (15) of a plurality (10) of loads, an operation state of a load being a state in which said load (15) consumes or generates energy, said method including the steps of

obtaining (115) a plurality of mutually different data sets, each data set corresponding to a time interval, wherein each data set includes a total energy throughput of the plurality (10) of loads during said time interval and information on all operation states of each load (15) of the plurality (10) of loads during said time interval, the number of data sets being equal to or larger than the combined number of operation states of the plurality (10) of loads, and

calculating (125) a set of the individual power representations of the operation states of the plurality (10) of loads, said set providing a minimization, for all time intervals, of the differences between the obtained total energy throughput of the respective time interval and a combined energy throughput resulting from the operation states of the plurality (10) of loads during said respective time interval,

wherein the power representations are linear power representations corresponding to a constant power and including an energy offset and the calculating step includes calculating an energy throughput of an operation state based on the time period during which the operation state is active within the respective time interval, wherein said energy offset incorporates effects involved with start-up or switch-off of a load.

6. A computer program for determining an individual power representation of each operation state of each load (15) of a plurality of loads (10), the computer program comprising program code means for causing the device (35) according to claim 1 to carry out the steps of the method according to claim 5 when the computer program is run on said device (35).

**Patentansprüche**

1. Vorrichtung (35) zum Ermitteln einer individuellen Leistungsdarstellung von jedem Betriebszustand jeder Last (15) einer Vielzahl (10) von Lasten, wobei ein Betriebszustand einer Last (15) ein Zustand ist, in dem die Last (15) Energie verbraucht oder erzeugt, wobei die Vorrichtung (35) umfasst:

eine Empfangseinheit (40) zum Empfangen einer Vielzahl von voneinander verschiedenen Datensätzen, wobei jeder Datensatz einem Zeitintervall entspricht, wobei jeder Datensatz einen gesamten Energiedurchsatz der Vielzahl (10) von Lasten während dieses Zeitintervalls und Informationen über alle Betriebszustände jeder Last (15) der Vielzahl (10) von Lasten während dieses Zeitintervalls enthält, wobei die Anzahl von Datensätzen der kombinierten Anzahl von Betriebszuständen der Vielzahl (10) von Lasten entspricht oder größer als diese ist, sowie

eine Berechnungseinheit (45) zum Berechnen eines Satzes der individuellen Leistungsdarstellungen der Betriebszustände der Vielzahl (10) von Lasten, wobei dieser Satz für alle Zeitintervalle eine Minimierung der Differenzen zwischen dem erlangten gesamten Energiedurchsatz des jeweiligen Zeitintervalls und einem kombinierten Energiedurchsatz vorsieht, der aus den Betriebszuständen der Vielzahl (10) von Lasten während des jeweiligen Zeitintervalls resultiert,

wobei die Leistungsdarstellungen lineare Leistungsdarstellungen sind, die einer konstanten Leistung entsprechen und einen Energieoffset beinhalten, und die Berechnungseinheit (45) so eingerichtet ist, dass sie einen Energiedurchsatz eines Betriebszustands auf der Basis der Zeitperiode berechnet, in der der Betriebszustand innerhalb des jeweiligen Zeitintervalls aktiv ist, wobei dieser Energieoffset Effekte inkorporiert, die mit dem Einschalten oder Ausschalten einer Last verbunden sind.

2. Vorrichtung (35) nach Anspruch 1,

wobei die Empfangseinheit (40) so eingerichtet ist, dass sie Datensätze entsprechend Zeitintervallen erhält, in denen keine Änderung der Betriebszustände der Lasten erfolgt.

3. System (55) zum Ermitteln einer individuellen Leistungsdarstellung von jedem Betriebszustand jeder Last (15) einer Vielzahl (10) von Lasten, wobei das System (55) umfasst:

die Vorrichtung (35) nach Anspruch 1,
ein Energiemessgerät (25) zur Messung eines gesamten Energiedurchsatzes für ein vorgegebenes Zeitintervall, sowie
einen Zustandsmonitor (30) zur Überwachung der Betriebszustände der Lasten (15) sowie zur Erzeugung der Informationen über alle Betriebszustände jeder Last (15) der Vielzahl (10) von Lasten während dieses Zeitintervalls.

4. Anordnung (60) zur Überwachung auf eine Funktionsstörung einer Last (15) einer Vielzahl (10) von Lasten, wobei diese Anordnung (60) umfasst:

das System (55) nach Anspruch 3, sowie
einen Störungsmonitor (50) zur Überprüfung auf eine Veränderung der Leistungsdarstellungen der durch dieses System (55) ermittelten Betriebszustände der Vielzahl (10) von Lasten.

5. Verfahren zum Ermitteln einer individuellen Leistungsdarstellung von jedem Betriebszustand jeder Last (15) einer Vielzahl (10) von Lasten, wobei ein Betriebszustand einer Last ein Zustand ist, in dem die Last (15) Energie verbraucht oder erzeugt, wobei das Verfahren die folgenden Schritte umfasst, wonach:

eine Vielzahl von voneinander verschiedenen Datensätzen erhalten wird (115), wobei jeder Datensatz einem Zeitintervall entspricht, wobei jeder Datensatz einen gesamten Energiedurchsatz der Vielzahl (10) von Lasten während dieses Zeitintervalls und Informationen über alle Betriebszustände jeder Last (15) der Vielzahl (10) von Lasten während dieses Zeitintervalls enthält, wobei die Anzahl von Datensätzen der kombinierten Anzahl von Betriebszuständen der Vielzahl (10) von Lasten entspricht oder größer als diese ist, und
ein Satz der individuellen Leistungsdarstellungen der Betriebszustände der Vielzahl (10) von Lasten berechnet wird (125), wobei dieser Satz für alle Zeitintervalle eine Minimierung der Differenzen zwischen dem erlangten gesamten Energiedurchsatz des jeweiligen Zeitintervalls und einem kombinierten Energiedurchsatz vorsieht, der aus den Betriebszuständen der Vielzahl (10) von Lasten während des jeweiligen Zeitintervalls resultiert, wobei die Leistungsdarstellungen lineare Leistungsdarstellungen sind, die einer konstanten Leistung entsprechen und einen Energieoffset beinhalten, und der Berechnungsschritt das Berechnen eines Energiedurchsatzes eines Betriebszustands auf der Basis der Zeitperiode beinhaltet, in der der Betriebszustand innerhalb des jeweiligen Zeitintervalls aktiv ist, wobei der Energieoffset Effekte inkorporiert, die mit dem Einschalten oder Ausschalten einer Last verbunden sind.

6. Computerprogramm zum Ermitteln einer individuellen Leistungsdarstellung von jedem Betriebszustand jeder Last (15) einer Vielzahl (10) von Lasten, wobei das Computerprogramm Programmcodemittel umfasst, um die Vorrichtung (35) nach Anspruch 1 zu veranlassen, die Schritte des Verfahrens nach Anspruch 5 auszuführen, wenn das Computerprogramm auf dieser Vorrichtung (35) abläuft.

**Revendications**

1. Dispositif (35) pour déterminer une représentation de puissance individuelle de chaque état de fonctionnement de chaque charge (15) d'une pluralité (10) de charges, un état de fonctionnement d'une charge (15) étant un état dans lequel ladite charge (15) consomme ou génère de l'énergie, ledit dispositif (35) incluant
une unité d'obtention (40) pour obtenir une pluralité d'ensembles de données mutuellement différents, chaque ensemble de données correspondant à un intervalle de temps, dans lequel chaque ensemble de données inclut une production énergétique totale de la pluralité (10) de charges durant ledit intervalle de temps et des informations sur tous les états de fonctionnement de chaque charge (15) de la pluralité (10) de charges durant ledit intervalle de temps, le nombre d'ensembles de données étant supérieur ou égal au nombre combiné d'états de fonctionnement de la pluralité (10) de charges, et
une unité de calcul (45) pour calculer un ensemble des représentations de puissance individuelles des états de fonctionnement de la pluralité (10) de charges, ledit ensemble fournissant une minimisation, pour tous les intervalles de temps, des différences entre la production énergétique totale obtenue de l'intervalle de temps respectif et une production énergétique combinée résultant des états de fonctionnement de la pluralité (10) de charges durant ledit intervalle de temps respectif,
dans lequel les représentations de puissance sont des représentations de puissance linéaires correspondant à une puissance constante et incluant un décalage énergétique et l'unité de calcul (45) est agencée pour calculer une production énergétique d'un état de fonctionnement sur la base de la période de temps durant laquelle l'état de fonctionnement est actif au cours de l'intervalle de temps respectif, dans lequel ledit décalage énergétique incorpore les effets liés au démarrage ou à l'arrêt d'une charge.

2.  Dispositif (35) selon la revendication 1,
    dans lequel l'unité d'obtention (40) est agencée pour obtenir des ensembles de données correspondant à des intervalles de temps durant lesquels aucun changement des états de fonctionnement des charges ne se produit.

3.  Système (55) pour déterminer une représentation de puissance individuelle de chaque état de fonctionnement de chaque charge (15) d'une pluralité (10) de charges, ledit système (55) incluant
    le dispositif (35) selon la revendication 1,
    un compteur d'énergie (25) pour mesurer une production énergétique totale pour un intervalle de temps donné, et
    un appareil de surveillance d'état (30) pour surveiller les états de fonctionnement des charges (15) et pour générer les informations sur tous les états de fonctionnement de chaque charge (15) de la pluralité (10) de charges durant ledit intervalle de temps.

4.  Agencement (60) pour déceler un dysfonctionnement d'une charge (15) dans une pluralité (10) de charges, ledit agencement (60) incluant
    le système (55) selon la revendication 3, et
    un appareil de surveillance de dysfonctionnement (50) pour détecter un changement des représentations de puissance des états de fonctionnement de la pluralité (10) de charges déterminées par ledit système (55).

5.  Procédé pour déterminer une représentation de puissance individuelle de chaque état de fonctionnement de chaque charge (15) d'une pluralité (10) de charges, un état de fonctionnement d'une charge étant un état dans lequel ladite charge (15) consomme ou génère de l'énergie, ledit procédé incluant les étapes de
    obtention (115) d'une pluralité d'ensembles de données mutuellement différents, chaque ensemble de données correspondant à un intervalle de temps, dans lequel chaque ensemble de données inclut une production énergétique totale de la pluralité (10) de charges durant ledit intervalle de temps et des informations sur tous les états de fonctionnement de chaque charge (15) de la pluralité (10) de charges durant ledit intervalle de temps, le nombre d'ensembles de données étant supérieur ou égal au nombre combiné d'états de fonctionnement de la pluralité (10) de charges, et
    calcul (125) d'un ensemble des représentations de puissance individuelles des états de fonctionnement de la pluralité (10) de charges, ledit ensemble fournissant une minimisation, pour tous les intervalles de temps, des différences entre la production énergétique totale obtenue de l'intervalle de temps respectif et une production énergétique combinée résultant des états de fonctionnement de la pluralité (10) de charges durant ledit intervalle de temps respectif,
    dans lequel les représentations de puissance sont des représentations de puissance linéaires correspondant à une puissance constante et incluant un décalage énergétique et l'étape de calcul inclut le calcul d'une production énergétique d'un état de fonctionnement sur la base de la période de temps durant laquelle l'état de fonctionnement est actif au cours de l'intervalle de temps respectif, dans lequel ledit décalage énergétique incorpore les effets liés au démarrage ou à l'arrêt d'une charge.

6.  Programme informatique pour déterminer une représentation de puissance individuelle de chaque état de fonctionnement de chaque charge (15) d'une pluralité de charges (10), le programme informatique comprenant un moyen de code de programme pour amener le dispositif (35) selon la revendication 1 à réaliser les étapes du procédé selon la revendication 5 lorsque le programme informatique est exécuté sur ledit dispositif (35).

FIG. 1

FIG. 2

FIG. 3

## REFERENCES CITED IN THE DESCRIPTION

**Patent documents cited in the description**

- WO 2011130670 A2

**Non-patent literature cited in the description**

- **HART, G.W.** Non-intrusive Appliance Load Monitoring. *Proc. of IEEE,* December 1992, vol. 80 (12), 1870-1891

- **PHILIP E. GILL ; WALTER MURRAY ; MARGATER H. WRIGHT.** Practical Optimization. Academic Press, 1981